# EUROPÄISCHE PATENTSCHRIFT

(11) **EP 1 705 977 B1**
(45) Veröffentlichungstag und Bekanntmachung des Hinweises auf die Patenterteilung: **03.01.2007**
(21) Anmeldenummer: 05005938.5
(22) Anmeldetag: 18.03.2005
(51) Int. Cl.: H05K 7/20

(54) **Gehäuse zur Aufnahme von elektronischen Steckbaugruppen**
Housing for mounting plugable electronic units
Boîtier pour abriter des unités électroniques enfichables

(43) Veröffentlichungstag der Anmeldung: 27.09.2006
(73) Patentinhaber: Schroff GmbH, D-75334 Straubenhardt (DE)
(72) Erfinder: Kempf, Heinz, 75365 Calw-Altburg (DE); Euchner, Heinz, 75217 Birkenfeld (DE); Günther, Hans-Ulrich, 76327 Pfinztal (DE)
(74) Vertreter: Durm, Klaus

(56) Entgegenhaltungen:
- SU-A1- 1 101 588
- US-A- 5 540 548
- US-A- 5 772 500
- US-A1- 2003 214 785
- US-B1- 6 252 770

## Beschreibung

Die vorliegende Erfindung betrifft ein Gehäuse zur Aufnahme von elektronischen Steckbaugruppen, mit einem zur Vorderseite des Gehäuses hin offenen Einbauraum für die Steckbaugruppen, einem unter dem Einbauraum vorgesehenen Luftansaugraum und einem oberhalb des Einbauraums liegenden Lüfterraum, in dem mindestens zwei Radiallüfter hintereinander angeordnet sind. Der Einbauraum wird im Wesentlichen in vertikaler Richtung von Kühlluft durchströmt.

Mehrere solcher Gehäuse werden üblicherweise in Schaltschränke eingebaut. Um möglichst viele Gehäuse in einen Schaltschrank aufnehmen zu können, soll das einzelne Gehäuse möglichst niedrig sein. Je niedriger die Bauhöhe des Gehäuses ist, desto besser kann der zur Verfügung stehende Raum im Schaltschrank genutzt werden. Die auf die Standfläche des Schaltschrankes bezogenen Kosten werden dadurch reduziert.

Gleichzeitig steigt aber die Packungsdichte der elektronischen Steckbaugruppen aufgrund der fortschreitenden Miniaturisierung immer mehr an. Es werden immer mehr Baugruppen auf immer engerem Raum plaziert. Die abzuführende Verlustleistung der Steckbaugruppe erhöht sich damit stetig. Dies hat zur Folge, dass an den Baugruppenträger und die Gehäuse besondere Anforderungen in Bezug auf die Kühlung gestellt werden.

Insbesondere im Bereich von Telekommunikationseinrichtungen sind die Anforderungen an die Kühlung sehr stark gestiegen und werden in Zukunft weiter zunehmen. Der für Telekommunikationsanwendungen von der PICMG (PCI Industrial Computing Manufacture Group) entwickelte ATCA-Standard (Advanced Telecom Computing Architecture) lässt eine Verlustleistung von bis zu 200 Watt pro Steckbaugruppe zu. Üblicherweise werden im einem Gehäuse für Telekommunikationsanwendungen 14 bis 16 Steckbaugruppen nebeneinander plaziert. Die Gesamtverlustleistung liegt damit bei etwa 3.000 Watt. Um eine Überhitzung des Gehäuses zu verhindern, muss diese Wärmeleistung effektiv und ausfallsicher abgeführt werden.

Die immer größer werdende Verlustleistung steht der Anforderung nach einer möglichst geringen Gesamtbauhöhe diametral entgegen. Um die im Baugruppenträger oder Gehäuse entstehende Wärme abzuführen, muss die Kühlleistung der Kühlsysteme erhöht werden. Es bedarf möglichst großer und starker Lüfter. Starke Lüfter benötigen allerdings entsprechend viel Platz. Gleichzeitig erfordert eine hohe Kühlleistung große Lufteintritts- und Austrittsquerschnitte sowie eine strömungsgünstig gestaltete Luftführung mit möglichst geringem Luftwiderstand innerhalb des Gehäuses. Da die Höhe des Einbauraums für die Steckbaugruppen durch die Norm fest vorgegeben ist, lässt sich die Gesamthöhe des Gehäuses nur reduzieren, wenn der Raum für die Lüfter so weit wie möglich verringert wird. Dies ist jedoch nicht ohne weiteres möglich, wenn eine sehr große Kühlleistung gefordert wird und ein entsprechend starker und groß dimensionierter Lüfter eingesetzt werden muss.

Als zusätzliche Anforderung wird von den Systemen für die Telekommunikation eine Systemverfügbarkeit von mindestens 99,999% erwartet. Eine derart hohe Ausfallsicherheit von wenigen Minuten pro Jahr bei Systemen im Dauerbetrieb lässt sich nur mit redundant aufgebauten Systemen gewährleisten. Wie alle anderen wichtigen Komponenten eines Telekommunikationssystems nach dem AT-CA-Standard, müssen also auch die Lüfter mehrfach redundant ausgelegt werden.

Aus physikalischer Sicht wird eine ideale Entlüftung durch einen maximal gro-ßen Lüfter erzeugt. Der Gesamtwirkungsgrad ist dann größer als beim Einsatz mehrerer kleiner Lüfter. Mehrere kleine Lüfter reduzieren aber das Risiko der Überwärmung bei Ausfall eines einzelnen Lüfters. Die verbleibende Luftleistung muss bei Ausfall eines Lüfters immer noch so ausreichend bemessen sein, dass es zu keiner Überhitzung des Systems kommt. Die Luftmengenreserve muss ausreichend groß bemessen sein. Hier muss also ein wirtschaftlicher und technisch sinnvoller Kompromiss gesucht werden zwischen möglichst hoher Luftleistung im Normalbetrieb und möglichst geringem Verlust an Kühlleistung bei Ausfall eines Lüfters.

Bekannt sind Telekommunikationssysteme, bei denen mehrere kleine Lüfter unterhalb der Steckbaugruppen im Gehäuse angeordnet sind. Diese als Axiallüfter ausgeführten Lüfter saugen kühle Luft an und drücken sie an den Steckbaugruppen entlang nach oben. Da die Lüfter von der einströmenden kühlen Luft umströmt werden, ist deren Temperaturbelastung gering, was sich positiv auf die Lebensdauer auswirkt.

Es sind Gehäuse bekannt, bei denen Axiallüfter oberhalb der Steckbaugruppen angeordnet sind. Nachteilig ist hier jedoch, dass ein relativ großer Raum oberhalb der Lüfter zur Verfügung gestellt werden muss, damit die Abluft effektiv von den Steckbaugruppen abgesaugt werden kann und es zu keinem Luftstau oberhalb der Lüfter kommt. Dies läuft jedoch der Anforderung nach einer möglichst geringen Bauhöhe des Gesamtsystems entgegen.

Anstelle von Axiallüftern werden im Stand der Technik auch Radiallüfter eingesetzt, die konstruktionsbedingt bereits eine 90°-Umlenkung des Luftstroms umfassen. Die von unten angesaugte Abluft wird seitlich ausgeblasen. Es muss also kein zusätzlicher Raum oberhalb der Lüfter zur Verfügung gestellt werden. Da aus Gründen der Redundanz aber mehrere Lüfter eingesetzt werden sollen, müssen die Lüfter in der Höhe versetzt angeordnet sein, damit die Abluftströme ungehindert seitlich vom Lüfter wegströmen können, ohne durch andere Lüfter behindert zu werden. Je mehr Lüfter in einer Reihe eingebaut werden, desto höher ist der notwendige Höhenversatz der einzelnen Lüfter gegeneinander. Der benötigte Raum zur Anordnung der Lüfter muss dabei eine Höhe aufweisen, die dem Mehrfachen der Höhe eines einzelnen Lüfters entspricht.

Ein Baugruppenträger, bei dem insgesamt vier Radiallüfter im Lüfterraum oberhalb der Steckbaugruppen angeordnet sind, wird beispielsweise von der Firma Rittal hergestellt. Jeder Radiallüfter ist in einer separaten Kapselung eingebaut. Die vier Radiallüfter sind in zwei Reihen angeordnet, wobei die vordere Reihe oberhalb der hinteren Reihe montiert ist. Durch diese Anordnung sind die Lüfter einzeln austauschbar. Bei Ausfall eines Lüfters stehen noch 75% der Gesamtkühlleistung zur Verfügung. Der Abluftstrom der vorderen Lüfter wird nicht durch die hinteren Lüfter beeinträchtigt, da die Abluft der vorderen Lüfter in horizontaler Richtung oberhalb der hinteren Lüfter weggeführt wird. Dies hat jedoch den Nachteil, dass der benötigte Raum für die Lüfter doppelt so hoch sein muss wie eine einzelne Lüfterkassette.

Aufgabe der vorliegenden Erfindung ist es nun, ein Gehäuse zur Aufnahme von elektronischen Steckbaugruppen zu schaffen, das eine möglichst geringe Bauhöhe hat und trotzdem mehrere Lüfter zur Erzeugung einer maximalen Kühlleistung aufnimmt.

Zur Lösung der Aufgabe wird von einem Gehäuse zur Aufnahme von elektronischen Baugruppen ausgegangen, das einen zur Vorderseite des Gehäuses offenen Einbauraum für Steckbaugruppen hat, einen unter dem Einbauraum vorgesehenen Luftansaugraum und einen oberhalb des Einbauraums liegenden Lüfterraum, in dem mindestens zwei Radiallüfter hintereinander angeordnet sind. Der Einbauraum wird dabei im Wesentlichen in vertikaler Richtung von Kühlluft durchströmt.

Gelöst wird die Aufgabe durch die kennzeichnenden Merkmale des Patentanspruchs 1.

Erfindungsgemäß ist zumindest der vordere Radiallüfter schräg geneigt angeordnet, so dass die Abluft des vorderen Radiallüfters im Wesentlichen über den hinteren Radiallüfter hinwegströmt. Durch die Neigung des vorderen Radiallüfters wird seine Abluft nicht gegen den dahinter angeordneten hinteren Lüfter gelenkt. Die Neigung muss so gewählt sein, dass der Abluftstrom im Wesentlichen an dem hinteren Lüfter vorbeiströmt, damit es zu keinen unnötigen Verwirbelungen kommt und die Luftleistung der Abluftstrom des vorderen Radiallüfters nicht durch den hinteren Lüfter behindert wird. Außerdem wird durch eine derartige Anordnung vermieden, dass der Motor des hinteren Lüfters vom warmen Abluftstrom des vorderen Lüfters zusätzlich aufgeheizt wird.

In einer vorteilhaften Ausführungsform des erfindungsgemäßen Gehäuses ist der hintere Radiallüfter im Wesentlichen horizontal angeordnet, während der vordere Radiallüfter um einen spitzen Winkel gegenüber der Horizontalen geneigt ist. Somit ist die dem hinteren Radiallüfter zugewandte Ausströmöffnung des vorderen Lüfters erhöht. Der Abluftstrom des vorderen Lüfters wird dadurch über den hinteren Lüfter hinweg gelenkt. Die Achse des vorderen Radiallüfters ist also aus der Vertikalen nach vorne gekippt, während die Achse des hinteren Lüfters im Wesentlichen vertikal angeordnet ist. Durch die schräge Anordnung des vorderen Radiallüfters vergrößert sich die benötigte Bauhöhe des Lüfterraums nur relativ wenig im Vergleich zu hintereinander horizontal angeordneten Lüftern. Der zusätzliche Bedarf an Raumhöhe ist abhängig vom Grad der Neigung des vorderen Radiallüfters. Der Neigungswinkel wiederum wird bestimmt durch den Durchmesser und die Bauhöhe der verwendeten Radiallüfter. Bei zwei hintereinander schräg versetzt angeordneten Radiallüftern erhöht sich der Lüfterraum nur um etwa 50% gegenüber 100% bei übereinander angeordneten Lüftern. Damit ist der Raumbedarf insgesamt deutlich geringer als bei zwei in der Höhe versetzt angeordneten Radiallüftern, die beide horizontal ausgerichtet sind.

Besonders bevorzugt wird ein Neigungswinkel des vorderen Radiallüfters zwischen 10° und 40° gegenüber der Horizontalen. Im praktischen Einsatz hat sich ein Neigungswinkel von ca. 30° besonders bewährt. Der optimale Neigungswinkel ist abhängig von der Bauhöhe und der Größe des einzelnen Lüfters. Werden mehr als zwei Lüfter im Gehäuse eingesetzt, so ist jedenfalls der hintere Radiallüfter im Wesentlichen horizontal angeordnet. Die anderen Lüfter sind gegenüber der Horizontalen geneigt, wobei die Neigung immer größer wird, je näher der Radiallüfter zur Vorderseite des Gehäuses hin positioniert ist. Die optimale Neigung der einzelnen Lüfter hängt auch von der Position und Größe der seitlichen Luftauslässe ab.

In vorteilhafter Weise hat jeder Radiallüfter einen eigenen Luftführungsraum. Die Abluftströme der beiden Radiallüfter sind so völlig voneinander getrennt, wodurch eine Vermischung der Abluftströme ausgeschlossen ist. Es kommt zu keinerlei Verwirbelungen oder pneumatischen Kurzschlüssen, die insbesondere dann auftreten würden, wenn die Abluftströme unterschiedliche Temperaturen aufweisen. Die Kühlleistung und die Effektivität der Radiallüfter werden weiter gesteigert.

Besonders vorteilhaft erweist sich eine Ausführungsform des erfindungsgemäßen Gehäuses, bei der der Lüfterraum mehrere Kassetten nebeneinander aufnimmt, wobei jede Kassette mindestens einen vorderen Radiallüfter und einen hinteren Radiallüfter enthält. Die Kassetten sind unabhängig voneinander aus- und einschiebbar. Jede Kassette kann einzeln ausgetauscht werden. Bei Ausfall eines einzelnen Lüfters kann eine der Kassetten aus dem Gehäuse herausgezogen werden und der Lüfter ersetzt werden. Die anderen Lüfter bzw. Kassetten werden vom Austausch nicht beeinträchtigt. Vorzugsweise weisen die Kassetten an ihren Seiten Trennbleche auf, so dass die Luftströme in den einzelnen Kassetten voneinander entkoppelt sind. Es findet keine Rückwirkung der Luftführung in einer Kassette auf andere Kassetten statt.

In einer bevorzugten Ausführungsform des Gehäuses weist der Luftansaugraum im Bereich der Vorderseite des Gehäuses einen Lufteinlass auf. Frischluft wird durch den Lufteinlass der Vorderseite in das Gehäuse geleitet. Die Luft wird dann von den oberhalb des Einbauraums befindlichen Lüftern angesaugt und strömt im Wesentlichen vertikal an den Steckbaugruppen vorbei bzw. durch diese hindurch nach oben. Die Anordnung der Lufteinlassbereiche an der Vorderseite des Gehäuses haben den Vorteil, dass sie frei zugänglich sind und bei Verschmutzungen auf einfache Art und Weise gereinigt werden können. Auch ist sichergestellt, dass genügend Luft in das Gehäuse einströmen kann, da die Vorderseite des Gehäuses in der Regel frei bleibt.

Bevorzugt befindet sich der Luftauslass im Bereich der Rückseite des Gehäuses. Die von den Lüftern von unten angesaugte Luft wird durch die Radiallüfter um 90% umgelenkt und im Wesentlichen horizontal durch die Lüftungskanäle dem Luftauslass zugeführt.

Ein Ausführungsbeispiel der Erfindung wird nachstehend anhand der beigefügten Abbildungen näher erläutert. Es zeigen:
- Figur 1: einen Querschnitt durch ein Gehäuse mit einem Einbauraum, einem Ansaugraum und einem Lüfterraum; und
- Figur 2: eine perspektivische Ansicht des Gehäuses von Fig. 1.

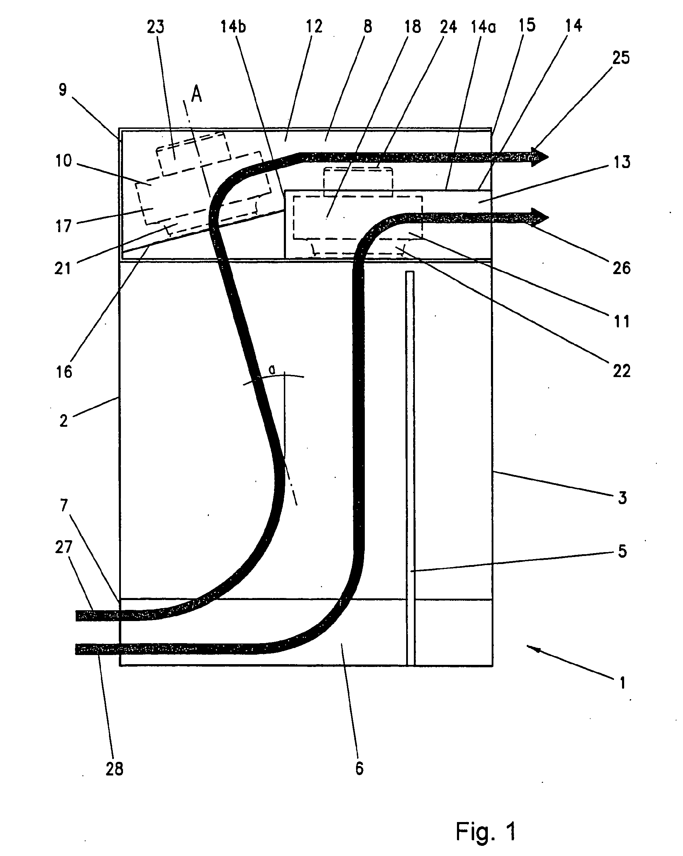

Figur 1 zeigt das Gehäuse 1 mit seiner Vorderseite 2 und seiner Rückseite 3 im Schnitt. Ein Einbauraum 4 ist zur Vorderseite 2 des Gehäuses 1 hin offen. Der Einbauraum 4 dient zur Aufnahme von elektronischen Steckbaugruppen, die von der Vorderseite 2 in den Einbauraum 4 hineingeschoben werden. Im Bereich der Rückseite 3 des Einbauraums 4 ist eine Rückverdrahtungsplatine, die sogenannte Backplane 5 angeordnet. Die (nicht gezeigten) Steckbaugruppen werden in diese Backplane 5 eingesteckt.

Unterhalb des Einbauraums 4 ist ein Luftansaugraum 6 vorgesehen. In den hinteren Bereich des Luftansaugraums 6 ragt die Backplane 5 hinein. Im Bereich der Vorderseite 2 weist der Luftansaugraum 6 einen Lufteinlass 7 auf, durch den Frischluft in das Gehäuse einströmen kann.

Oberhalb des Einbauraums 4 ist ein Lüfterraum 8 vorgesehen. Im Lüfterraum 8 sind Kassetten 9 vorgesehen, die zwei Radiallüfter 10, 11 umfassen. Der vordere Radiallüfter 10 ist schräg versetzt vor dem hinteren Radiallüfter 11 angeordnet.

Die Kassette 9 ist durch Trennbleche in einen vorderen Luftführungsraum 12 und einen hinteren Luftführungsraum 13 unterteilt. Der hintere Luftführungsraum 13 wird durch ein L-förmiges Luftleitblech 14 gebildet. Der lange L-Schenkel 14a des Luftleitbleches 14 ist horizontal ausgerichtet. Seine Länge entspricht etwa 60% der Gesamttiefe des Gehäuses 1. Der kurze L-Schenkel 14b des Luftleitblechs 14 erstreckt sich vertikal zum Boden der Kassette 9 hin. Die Länge des kurzen L-Schenkels 14b des Luftleitblechs 14 entspricht der halben Höhe der Kassette 9.

Der Lüfterraum 8 weist an der Rückseite 3 des Gehäuses 1 einen Luftauslass 15 auf, durch den die warme Abluft aus dem Gehäuse 1 ausgeblasen wird. Die Kassetten 9 sind hinten offen. Damit kann die durch die Luftführungsräume 12, 13 der Kassetten 9 gedrückte Luft in die Umgebung entweichen.

Der vordere Radiallüfter 10 ist auf ein Montageblech 16 montiert. Das Montageblech 16 ist unter einem Neigungswinkel α aus der Horizontalen gekippt. Folglich ist die Lüfterachse A des vorderen Radiallüfters 10 um denselben Winkel α aus der Vertikalen gekippt. Der Neigungswinkel α beträgt im vorliegenden Beispiel 30°. Das Montageblech 16 ist zwischen dem kurzen L-Schenkel 14b des Luftleitblechs 14 und der Frontseite der Kassette 9 montiert. Dabei ist das Montageblech 16 an der Frontseite der Kassette 9 um einige Millimeter vom Boden der Kassette 9 entfernt angebracht. Das gegenüberliegende Ende des Montageblechs 16 ist in der Nähe des oberen Endes des kurzen L-Schenkels 14b des Luftleitblechs 14 angebracht.

Die Radiallüfter 10, 11 weisen jeweils ein Lüfterrad 17 bzw. 18 auf. Unterhalb der Lüfterräder 17, 18 sind Ansaugtrichter 21 bzw. 22 angeordnet, die Luft in axialer Richtung einsaugen. Oberhalb der Lüfterräder 17 bzw. 18 befinden sich die Motorgehäuse 23 bzw. 24, in denen die Motoren für den Antrieb der Radiallüfter 10, 11 sitzen.

Das Motorgehäuse 24 des hinteren Radiallüfters 11 ragt durch das Luftleitblech 14 in den vorderen Luftführungsraum 12 hinein. Die Höhe des hinteren Luftführungsraums 13 ist somit geringer als die Bauhöhe des hinteren Radiallüfters 11.

Der Neigungswinkel α des Montageblechs 16 sowie die Höhe des Montageblechs 16 über der Horizontalen wird durch die Geometrie der beiden Radiallüfter 10, 11 bestimmt. Der vordere Radiallüfter 10 ist so schräg versetzt angeordnet, dass sein Abluftstrom 25 im Wesentlichen über das Motorgehäuse 24 des hinteren Radiallüfters 11 strömt. Der Abluftstrom 26 des hinteren Radiallüfters 11 verläuft vollständig in horizontaler Richtung. Eine gedachte Linie, die parallel zur Unterseite des Lüfterrades 17 des vorderen Radiallüfters 10 verläuft, endet etwa an der vorderen oberen Ecke des Motorgehäuses 24 des hinteren Radiallüfters 11. Damit der Abluftstrom 25 des vorderen Radiallüfters 10 möglichst horizontal verläuft, wird der Neigungswinkel α so klein wie möglich gehalten. Der Abluftstrom 25 soll unter einem möglichst spitzen Winkel gegen die Decke des Gehäuses 1 gelenkt werden, damit möglichst wenig Verwirbelungen entstehen. Hier ist ein Kompromiss aus Neigungswinkel α, Höhe des Montageblechs 16 und Gesamthöhe der Kassette 9 zu suchen. Die Höhe der Kassette 9 entspricht dem Doppelten der Höhe des hinteren Luftführungsraums 13.

In Figur 1 sind zusätzlich die Hauptluftströme der Kühlluft bzw. der Abluft eingezeichnet. Die Kühlluft strömt durch den Lufteinlass 7 an der Vorderseite 2 in den Luftansaugraum 6 ein und teilt sich dann in die beiden Kühlluftströme 27 bzw. 28. Diese durchströmen den Einbauraum 4 im Wesentlichen vertikal von unten nach oben und kühlen dabei die in der Backplane 5 eingesteckten (nicht dargestellten) Steckbaugruppen. Die Kühlluftströme 27, 28 werden von den Radiallüftern 10 bzw. 11 eingesaugt. Der vordere Kühlluftstrom 27 wird im oberen Bereich des Einbauraums 4 in Richtung der Lüfterachse A des vorderen Radiallüfters 10 gelenkt, so dass er axial in diesen Lüfter eintritt. Die in den Radiallüfter 10 axial eintretende Luft wird durch das Lüfterrad 17 radial ausgeblasen und strömt über das Motorgehäuse 24 des Radiallüfters 11 hinweg in Richtung Luftauslass 15.

Der hintere Kühlluftstrom 28 wird vertikal vom hinteren Radiallüfter 11 angesaugt. Aus dem Lüfterrad 18 des Radiallüfters 11 tritt der Abluftstrom 26 in Richtung Luftauslass 15 aus der Rückseite 3 des Gehäuses 1 aus. Der Abluftstrom 25 und der Abluftstrom 26 treten im Wesentlichen parallel aus dem Gehäuse 1 aus. Die Abluftströme 25, 26 sind jedoch durch das Luftleitblech 14 getrennt, so dass es zu keiner Vermischung oder gegenseitigen Störung kommt.

Zwischen der Rückseite 3 des Gehäuses 1 und der Backplane 5 können im Einbauraum 4 von der Rückseite her weitere schmale Steckbaugruppen in die Backplane 5 eingesetzt werden. Diese hinteren (ebenfalls nicht dargestellten) Steckbaugruppen haben eine Tiefe von 70 mm. Ihre Verlustleistung ist auf 15 Watt pro Steckbaugruppe durch die Norm begrenzt. Eine besondere Lüftung zur Abführung der entstehenden Verlustwärme ist nicht notwendig. Deshalb ist der hintere Radiallüfter 11 im Lüfterraum 8 so angeordnet, dass seine zur Rückseite 3 des Gehäuses 1 ausgerichtete Gehäuseseite im Wesentlichen mit der Backplane 5 im Einbauraum 4 abschließt. Es wird also keine bzw. nur sehr wenig Luft aus dem zwischen der Rückseite 3 und der Backplane 5 gebildeten Raum angesaugt.

Trotz der geringen Verlustleistung der Steckbaugruppen im Raum zwischen der Rückseite 3 und der Backplane 5 kann es notwendig sein, einen Teilluftstrom durch diesen Raum zu führen. Dies wird dadurch erreicht, dass im unteren Bereich der Backplane 5 Öffnungen vorgesehen sind. Zusätzlich ist der hintere Radiallüfter 11 zur Rückseite 3 verschoben, so dass er den Raum zwischen der Rückseite 3 und der Backplane 5 teilweise überlappt. Alternativ kann auch der hintere Radiallüfter 11 leicht aus der Horizontalen geneigt sein. Bevorzugt wird dabei eine Neigung um ca. 5°.

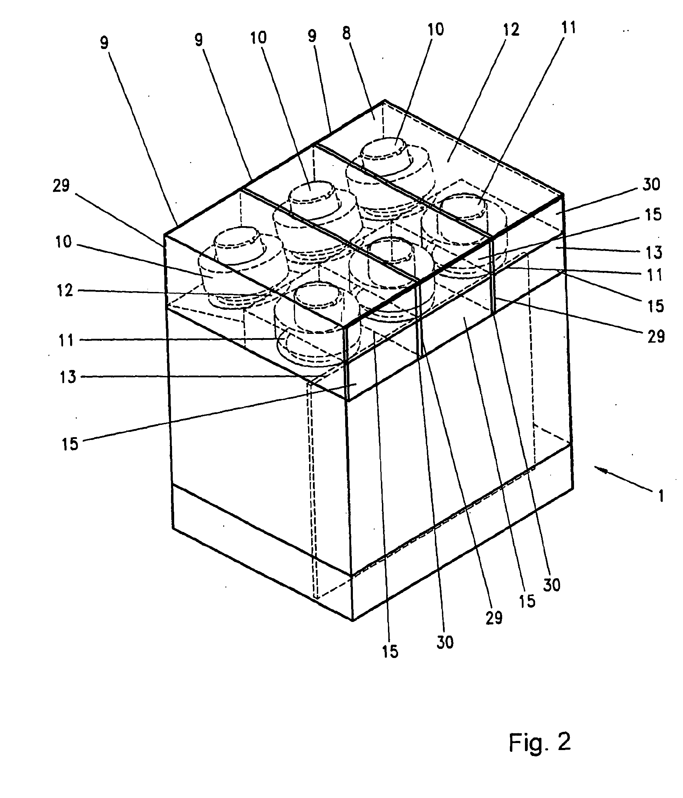

Figur 2 zeigt einen perspektivischen Blick auf das Gehäuse 1 von der hinteren Ecke aus. Im Lüfterraum 8 sind drei nebeneinander angeordnete Kassetten 9 eingeschoben, die jeweils einen vorderen Radiallüfter 10 und einen hinteren Radiallüfter 11 enthalten. Damit wird im Lüfterraum 8 eine Matrix aus insgesamt sechs Radiallüftern gebildet, die in zwei Reihen angeordnet sind. Jede Kassette 9 weist eine rechte Seitenwand 29 und eine linke Seitenwand 30 auf. Die Seitenwände 29, 30 begrenzen die Luftführungsräume 12, 13 jeweils seitlich. Die Abluftströme aller Radiallüfter der einzelnen Kassetten 9 sind somit vollständig entkoppelt.

Jede Kassette 9 lässt sich einzeln und unabhängig von den anderen Kassetten aus dem Gehäuse 1 entfernen. Bei einem Defekt eines Lüfters wird die betroffene Kassette 9 aus dem Gehäuse herausgezogen. Der defekte Lüfter wird ersetzt. Danach wird die Kassette 9 wieder in das Gehäuse 1 eingeschoben. Während des Austausches einer Kassette 9 reduziert sich die Abluft- bzw. Kühlleistung im Gehäuse 1 um 33%. Die Radiallüfter müssen also derart ausgelegt sein, dass bei einem kurzzeitigen Verzicht auf ein Drittel der Kühlleistung keine Überwärmung der Komponenten im Einbauraum 4 hervorgerufen wird.

An der Rückseite 3 des Gehäuses 1 sind im Lüfterraum 8 die Luftführungsräume 12, 13 der einzelnen Kassetten 9 zu erkennen. Die einzelnen Abluftströme werden aus den Luftführungsräumen 12, 13 durch die Luftauslässe 15 an der Rückseite 3 aus dem Gehäuse 1 ausgeleitet.

### Zusammenstellung der Bezugszeichen

- 1: Gehäuse
- 2: Vorderseite
- 3: Rückseite
- 4: Einbauraum
- 5: Backplane
- 6: Luftansaugraum
- 7: Lufteinlass
- 8: Lüfterraum
- 9: Kassette
- 10: (vorderer) Radiallüfter
- 11: (hinterer) Radiallüfter
- 12: Luftführungsraum (von 10)
- 13: Luftführungsraum (von 11)
- 14: Luftleitblech
- 14a: L-Schenkel (von 14)
- 14b: L-Schenkel (von 14)
- 15: Luftauslass
- 16: Montageblech
- 17: Lüfterrad (von 10)
- 18: Lüfterrad (von 11)
- 21: Ansaugtrichter (von 10)
- 22: Ansaugtrichter (von 11)
- 23: Motorgehäuse (von 10)
- 24: Motorgehäuse (von 11)
- 25: Abluftstrom (von 10)
- 26: Abluftstrom (von 11)
- 27: Kühlluftstrom
- 28: Kühlluftstrom
- 29: Seitenwand (von 9)
- 30: Seitenwand (von 9)
- α: Neigungswinkel
- A: Lüfterachse

## Patentansprüche

1. Gehäuse zur Aufnahme von elektronischen Steckbaugruppen, mit einem zur Vorderseite des Gehäuses hin offenen Einbauraum für die Steckbaugruppen, einem unter dem Einbauraum vorgesehenen Luftansaugraum und einem oberhalb des Einbauraums liegenden Lüfterraum, in dem mindestens zwei Radiallüfter hintereinander angeordnet sind, wobei der Einbauraum im Wesentlichen in vertikaler Richtung von Kühlluft durchströmt wird, **dadurch gekennzeichnet, dass** der hintere Radiallüfter (11) im Wesentlichen horizontal angeordnet ist und zumindest der vordere Radiallüfter (10) um einen spitzen Winkel gegenüber der Horizontalen geneigt angeordnet ist, so dass der Abluftstrom (25) des vorderen Radiallüfters (10) im Wesentlichen über den hinteren Radiallüfter (11) hinwegströmt.

2. Gehäuse nach Anspruch 1, **dadurch gekennzeichnet, dass** der Neigungswinkel (α) des vorderen Radiallüfters (10) gegenüber der Horizontalen zwischen 10° und 40°, vorzugsweise ungefähr 30°, beträgt.

3. Gehäuse nach Anspruch 1 oder 2, **dadurch gekennzeichnet, dass** jeder Radiallüfter (10, 11) einen getrennten Luftführungsraum (12, 13) hat.

4. Gehäuse nach einem der Ansprüche 1 bis 3, **dadurch gekennzeichnet, dass** der Lüfterraum (8) mehrere Kassetten (9) nebeneinander aufnimmt und die Kassetten (9) je mindestens einen vorderen Radiallüfter (10) und einen hinteren Radiallüfter (11) enthalten.

## Claims

1. Housing to receive electronic plug-in assemblies, with an installation space for the plug-in assemblies which is open to the front face of the housing, an air intake space which is provided below the installation space and a fan space which lies above the installation space and in which at least two radial fans are disposed one behind the other, wherein cooling air flows through the installation space in a substantially vertical direction, **characterised in that** the rear radial fan (11) is disposed substantially horizontally and at least the front radial fan (10) is disposed so that it is inclined at an acute angle to the horizontal so that the exhaust air stream from the front radial fan (10) flows away substantially via the rear radial fan (11).

2. Housing as claimed in Claim 1, **characterised in that** the angle of inclination (α) of the front radial fan (10) relative to the horizontal is between 10° and 40°, preferably approximately 30°.

3. Housing as clamed in Claim 1 or 2, **characterised in that** each radial fan (10, 11) has a separate air guiding space (12, 13).

4. Housing as claimed in any one of Claims 1 to 3, **characterised in that** the fan space (8) accommodates a plurality of cassettes (9) adjacent to one another and the cassettes (9) each contain at least one front radial fan (10) and one rear radial fan (11).

## Revendications

1. Boîtier pour abriter des unités électroniques enfichables, comprenant un compartiment de montage pour les unités enfichables ouvert en direction de la face avant du boîtier, un compartiment d'aspiration d'air prévu au-dessous du compartiment de montage, et un compartiment de ventilation, situé au-dessus du compartiment de montage et dans lequel sont disposés au moins deux ventilateurs radiaux l'un derrière l'autre, le compartiment de montage étant balayé essentiellement dans la direction verticale par l'air de refroidissement, **caractérisé en ce que** le ventilateur radial arrière (11) est disposé de façon essentiellement horizontale et au moins le ventilateur radial avant (10) est incliné sous un angle aigu par rapport à l'horizontale, de sorte que le flux d'air sortant (25) du ventilateur radial avant (10) s'échappe essentiellement au-dessus du ventilateur radial arrière (11).

2. Boîtier suivant la revendication 1, **caractérisé en ce que** l'angle d'inclinaison (α) du ventilateur radial avant (10) par rapport à l'horizontale est compris entre 10° et 40°, de préférence d'environ 30°.

3. Boîtier suivant l'une des revendications 1 et 2, **caractérisé en ce que** chaque ventilateur radial (10, 11) comporte un espace de guidage d'air séparé (12, 13).

4. Boîtier suivant l'une des revendications 1 à 3, **caractérisé en ce que** le compartiment de ventilation (8) abrite plusieurs cartouches (9) juxtaposées et les cartouches (9) comportent chacune au moins un ventilateur radial avant (10) et un ventilateur radial arrière (11).
